Europäisches Patentamt

European Patent Office    (11) Publication number:    **0 101 107**

Office européen des brevets    **A2**

(19)

## (12)    EUROPEAN PATENT APPLICATION

(21) Application number: 83201025.0    (51) Int. Cl.³: **G 11 C 29/00**

(22) Date of filing: 11.07.83

(30) Priority: 19.07.82 US 399534

(43) Date of publication of application:
22.02.84 Bulletin 84/8

(84) Designated Contracting States:
DE FR GB

(71) Applicant: MOTOROLA, INC.
1303 East Algonquin Road
Schaumburg Illinois 60196(US)

(72) Inventor: Bron, Michel
Simplon 3B
CH-1006 Lausanne(CH)

(72) Inventor: Gercekci, Anil
36 rue du Mole
CH-1201 Geneva(CH)

(74) Representative: Ibbotson, Harold
Motorola Inc Patent and Licensing Operations - Europe
Viables Industrial Estate
Basingstoke Hants RG22 4PD(GB)

(54) Method of testing a semiconductor memory array.

(57) This invention relates to a method of testing an array 15 of rows 8, 9 and columns 10, 11 floating gate avalanche injection MOS memory elements.

In the method a stress test is carried out by applying a stressing potential simultaneously to a plurality of rows 8, 9 or to a plurality of columns 10, 11 of the array 15. The invention is particularly useful in the testing of EPROMS.

FIG. 4

# METHOD OF TESTING A SEMICONDUCTOR MEMORY ARRAY

## TECHNICAL FIELD

This invention relates to a method of testing an array of MOS memory elements and is particularly applicable to an array of elements forming a so-called EPROM (Erasable and Programmable Read Only Memory).

## BACKGROUND ART

EPROM's are usually formed using so-called FAMOS technology (Floating-gate Avalanche Injection MOS). Each memory element consists of a single memory transistor having a substrate, source and drain electrodes and a control gate electrode. The transistor is therefore a four terminal device.

Located between the control gate and the substrate, in which the source and drain of the transistor are diffused, is a floating gate. The floating gate is spaced from the substrate by a layer of silicon oxide known as the "gate oxide" and is spaced from the control gate by a further layer of oxide known as the "interpoly oxide". The control gate and the floating gate are themselves usually formed by respective layers of polysilicon.

When a memory element transistor of this form is in the erased state there is no accumulated charge on the floating gate and the threshold voltage (i.e. the voltage necessary on the control gate to produce conduction between source and drain electrodes) is relatively low, being typically about 5 volts.

In order to programme the transistor it is necessary to apply a relatively high programming voltage, typically about 20 volts, simultaneously to both the control gate and the drain electrodes of the transistor. This produces a high value electric field between the floating gate and the substrate and also an avalanche current is created in a conducting channel extending between the source and drain electrodes.

Electrons are generated which have sufficient energy to jump to the floating gate, being attracted by the electric field across this gate. An electric charge will be accumulated on the floating gate and this will raise the threshold voltage of the transistor above typically 5 volts.

In order to read a memory transistor a voltage of about 5 volts is applied to the control gate electrode and a sense amplifier is used to detect whether or not current flows between the source and drain electrodes. A transistor which has no accumulated charge in its floating gate will conduct whilst a transistor

# METHOD OF TESTING A SEMICONDUCTOR MEMORY ARRAY

## TECHNICAL FIELD

This invention relates to a method of testing an array of MOS memory elements and is particularly applicable to an array of elements forming a so-called EPROM (Erasable and Programmable Read Only Memory).

## BACKGROUND ART

EPROM's are usually formed using so-called FAMOS technology (Floating-gate Avalanche Injection MOS). Each memory element consists of a single memory transistor having a substrate, source and drain electrodes and a control gate electrode. The transistor is therefore a four terminal device.

Located between the control gate and the substrate, in which the source and drain of the transistor are diffused, is a floating gate. The floating gate is spaced from the substrate by a layer of silicon oxide known as the "gate oxide" and is spaced from the control gate by a further layer of oxide known as the "interpoly oxide". The control gate and the floating gate are themselves usually formed by respective layers of polysilicon.

When a memory element transistor of this form is in the erased state there is no accumulated charge on the floating gate and the threshold voltage (i.e. the voltage necessary on the control gate to produce conduction between source and drain electrodes) is relatively low, being typically about 5 volts.

In order to programme the transistor it is necessary to apply a relatively high programming voltage, typically about 20 volts, simultaneously to both the control gate and the drain electrodes of the transistor. This produces a high value electric field between the floating gate and the substrate and also an avalanche current is created in a conducting channel extending between the source and drain electrodes.

Electrons are generated which have sufficient energy to jump to the floating gate, being attracted by the electric field across this gate. An electric charge will be accumulated on the floating gate and this will raise the threshold voltage of the transistor above typically 5 volts.

In order to read a memory transistor a voltage of about 5 volts is applied to the control gate electrode and a sense amplifier is used to detect whether or not current flows between the source and drain electrodes. A transistor which has no accumulated charge in its floating gate will conduct whilst a transistor

-3-

## BRIEF DESCRIPTION OF INVENTION

This invention seeks to provide a method of testing an array of floating gate avalanche injection MOS memory elements in which a bake test is avoided and test time reduced.

According to one aspect of the present invention there is provided a method of testing an array of rows and columns of floating gate avalanche injection MOS memory elements, each element including a transistor having a source electrode, drain electrode, control gate electrode and a floating gate, the transistors in a row having their gate electrodes electrically connected together and the transistors in a column having their drain electrodes electrically connected together the method including the steps of applying a stressing potential simultaneously to a plurality of rows or to a plurality of columns of the array.

The stressing potential may be applied simultaneously to all the rows of the array.

The stressing potential may be applied simultaneously to all the columns of the array.

According to a second aspect of the invention there is provided an array of rows and columns of floating gate avalanche injection MOS memory elements each element comprising a transistor having a source electrode, a drain electrode, a control gate electrode and a floating gate; the array including means for applying a stressing potential for test purposes simultaneously to a plurality of rows or to a plurality of columns of the array.

The means for applying a stressing potential may include means for applying a stressing potential simultaneously to all the rows of the array.

The means for applying a stressing potential may include means for applying a stressing potential simultaneously to all the columns of the array.

The array may include decoding means for enabling a programming potential to be applied to a selected row or column of the array, the means for applying a stressing potential including means for overriding the action of the decoding means.

-4-

The means for overriding the action of the decoding means may be operative to apply the programming potential as the stressing potential simultaneously to a plurality of rows or columns of the array.

The means for overriding the action of the decoding means may comprise gating means for enabling application of the programming potential as the stressing potential.

The gating means may be responsive to a stress test selecting signal.

## BRIEF DESCRIPTION OF DRAWINGS

An exemplary embodiment of the invention will now be described with reference to the drawings in which;

Figure 1 illustrates schematically a floating gate avalanche injection MOS transistor memory element;

Figure 2 shows an array of the elements of Figure 1;

Figure 3 shows the array of Figure 2 in more detail;

Figure 4 is a highly schematic block diagram of an array of memory elements in accordance with the present invention and

Figure 5 illustrates the array of Figure 4 in more detail.

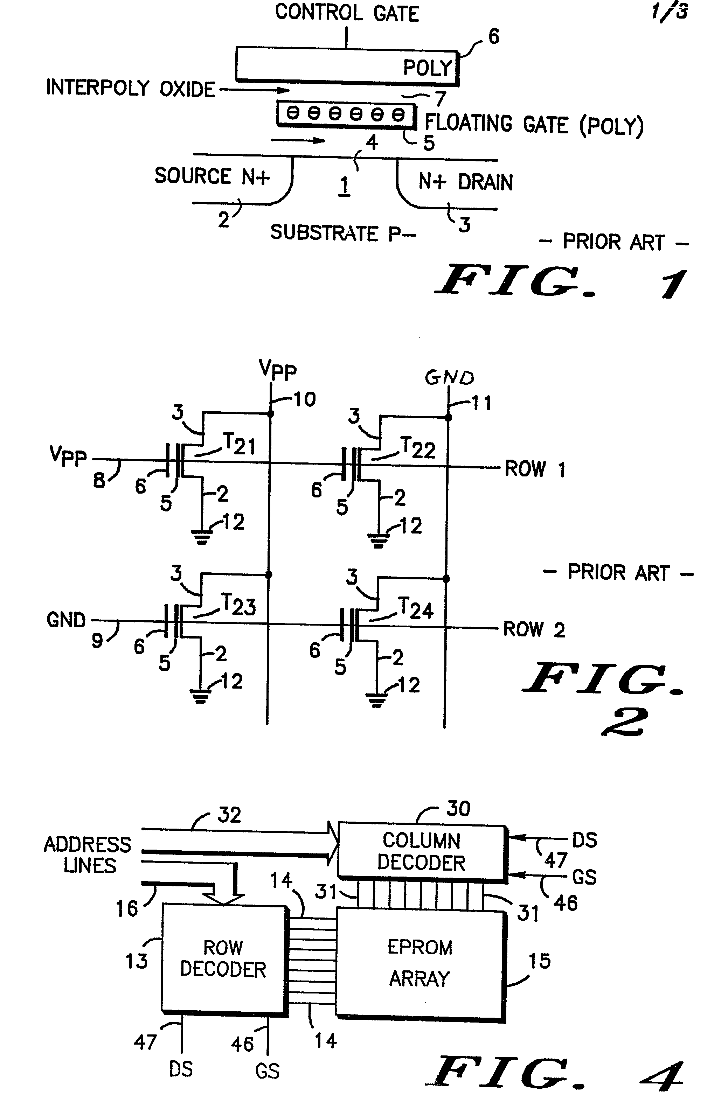

Referring now to Figure 1, there is shown a floating gate avalanche injection MOS transistor memory element which is formed by a P type silicon substrate 1 into which is diffused a $N^+$ source area 2 and an $N^+$ drain area 3. On the substrate 1 and extending between the source area 2 and the drain 3 is a layer of silicon oxide 4 which forms the gate oxide of the transistor. A polysilicon layer 5 overlies the gate oxide layer 4 and forms a so-called floating gate being electrically isolated from the substrate 1 by means of the gate oxide 4 and from a polysilicon control gate 6 by a further layer of silicon oxide 7, known as the interpoly oxide.

When this memory element transistor is in the erased state, there is no accumulated charge on the floating gate 5 and the threshold voltage of the device is relatively low being typically about two volts. In order to programme the transistor it is necessary to apply a relatively high programming voltage, typically about 20 volts, simultaneously to both the control gate 6 and to the drain electrode 3 of the transistor. This produces a high value electric field between the floating gate and the substrate and also an avalanche current is created in a conducting channel extending between the source electrode 2 and the drain electrode 3 of the transistor.

-5-

Electrons are generated with sufficient energy to jump to the floating gate 5 being attracted by the electric field across this gate and an electric charge is therefore accumulated on the floating gate 5. This raises the threshold voltage of the transistor above 5 volts.

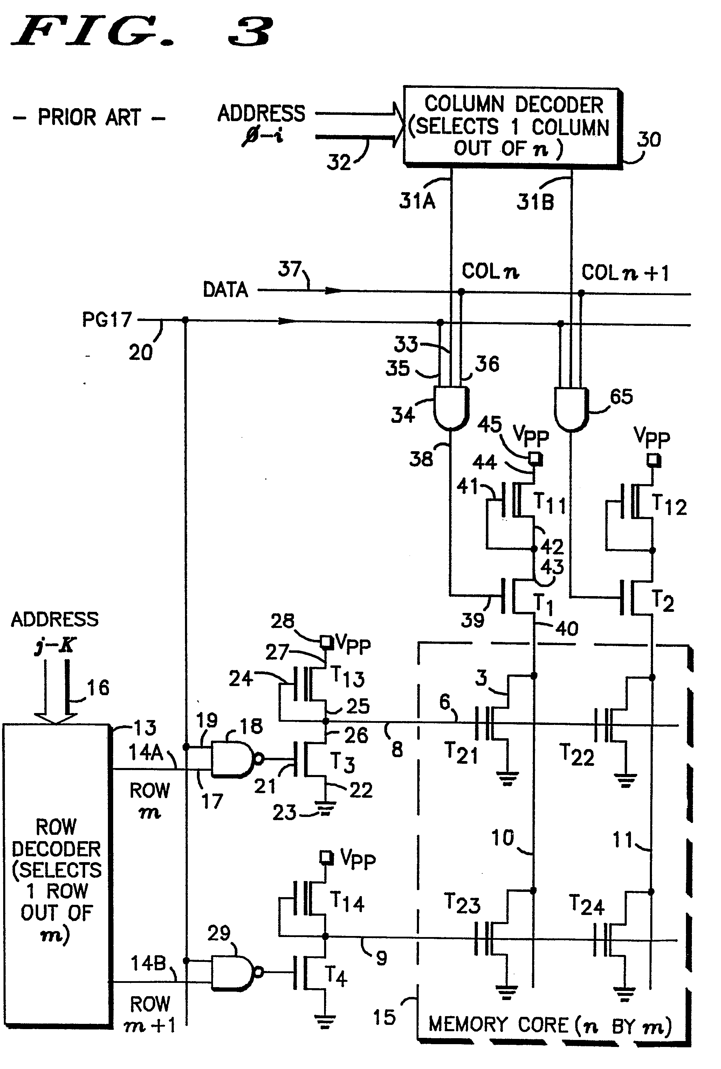

In order to form an erasable and programmable read only memory (EPROM) memory element, transistors of the form shown in Figure 1 are arranged as an array of rows and columns of transistors and such an array is illustrated in Figure 2 to which reference will now be made. In Figure 2 where like parts to those in Figure 1 bear like reference numerals there is shown part of a typical known array of transistors only four of which are illustrated for the purpose of simplicity. Two transistors T21 and T22 form a first row of the array and have their control gate electrodes 6 electrically connected together and to other transistors in the row by means of a row conductor 8. Transistors T23 and T24 form a second row of the array and these transistors in the second row have their control gate electrodes 6 electrically connected by means of a row conductor 9.

A first column of the array is formed by the transistors T21 and T23 which have their drain electrodes 3 electrically connected together and to the drain electrodes of other transistors in the column by means of a column conductor 10. Similarly, the transistors T22 and T24 form a second column of the array and have their drain electrodes 3 electrically connected together and to the drain electrodes of other transistors in the column by means of a column conductor 11. The source electrodes 2 of each transistor in the array are connected to a reference potential 12 typically earth potential.

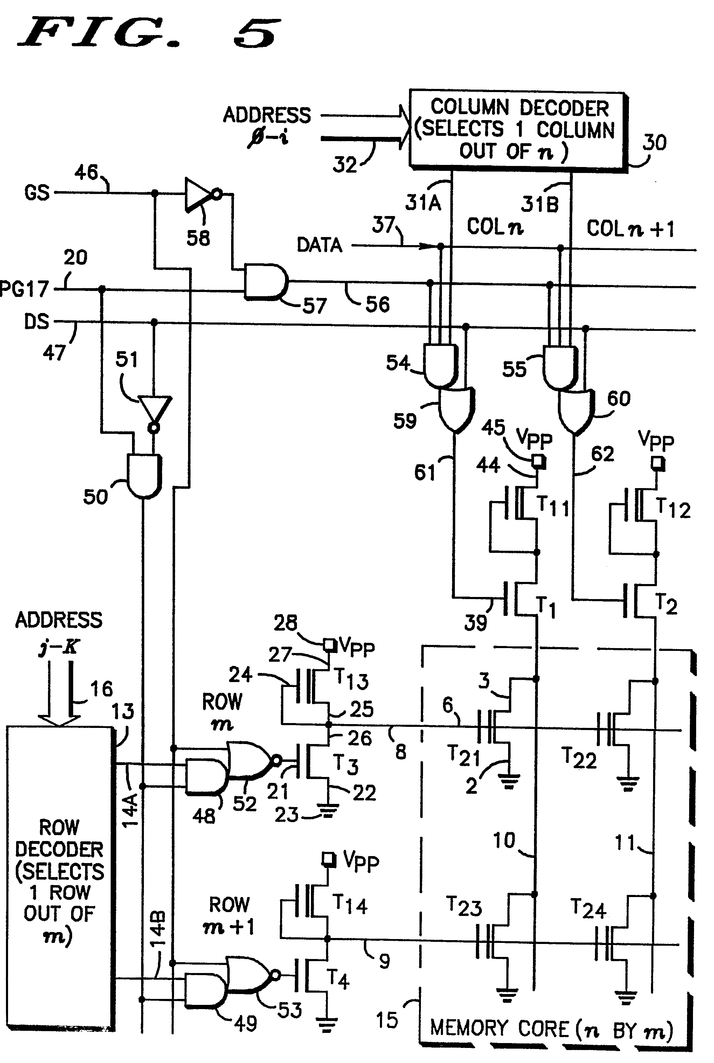

In order to programme a selected transistor, for example the transistor T21, this transistor is selected by placing a programming potential $V_{pp}$ on the row conductor 8 thereby selecting the row in which the transistor T21 lies, and by applying the programming potential $V_{pp}$ to the column conductor 10, thereby selecting the column in which the transistor T21 is located. This transistor T21 will therefore be the only transistor which has the requisite programming potentials applied to both its control gate electrode 6 and to its drain electrode 3. The programming of selected transistors will now be described with reference to Figure 3 which illustrates the array of Figure 2 in more detail.

In Figure 3 where like parts to those in Figure 2 bear like reference numerals, programming voltage for the row conductors 8 and 9 is selected by means of a row decoder 13. The row decoder 13 has a number of parallel outputs 14, one for each row of the array which is generally referenced 15. Only two outputs 14a and 14b of the row decoder 13 are shown corresponding to the illustrated row conductors 8 and 9 respectively of the array 15.

The row decoder 13 has an address input 16 for selecting a row of the array 15 and the decoder provides a logically high output on the appropriate row output 14 corresponding to the selected row. The output 14a is connected to one input 17 of a NAND gate 18, a second input 19 of which is connected to a programming input 20.

The NAND gate 18 has an output connected to a control gate 21 of a MOS field effect transistor T3 whose source electrode 22 is connected to earth reference potential 23. A depletion mode transistor T13 provides the load of the transistor T3 and has a gate electrode 24 and a source electrode 25 connected together and to a drain electrode 26 to the transistor T3. The transistor T13 also has a drain electrode 27 connected to a terminal 28 to which the programming potential $V_{pp}$ is applied. The row conductor 8 of the array 15 is connected to the drain electrode 26 of the transistor T3.

In similar manner the output 14b of the row decoder 13 enables the application of a programming potential to the row conductor 9 of the array 15 via a NAND gate 29 and transistor T4 and T14 which are arranged similarly to the gate 18 and the transistors T3 and T13.

In order to apply a programming potential to the column conductors 10 and 11 of the array 15 a column decoder 30 has parallel outputs 31 each of which corresponds to a column conductor of the array. For the purposes of explanation only two such outputs 31a and 31b are shown corresponding to the columns 10 and 11 respectively of the array.

As for the row decoder 13 the column decoder 30 has an address input 32 by means of which one of the outputs 31 is selected. The output 31 is connected to one input 33 of an AND gate 34, a second input 35 of which is connected to the programming input terminal 20 and a third input 36 of which is connected to a data input terminal 37.

The AND gate 34 has an output 38 connect to a gate 39 of a MOS field effect transistor T1. The transistor T1 has a source electrode 40 connected to the column conductor 10 and has a drain load provided in the form of a depletion mode transistor T11 whose gate electrode 41 is connected directly to its source electrode 42 and to drain electrode 43 of the transistor T1. Drain electrode 44 of the transistor T11 is connected to a terminal 45 to which the programming potential $V_{pp}$ is applied.

The output 31b of the column decoder 30 controls the application of the programming potential $V_{pp}$ to the column 11 via AND gate 65 and field effect transistor T2 having a drain load in the form of a depletion mode transistor T12, the AND gate 65, the transistor T2 and its drain load transistor T12 being arranged with respect to one another in exactly the same configuration as the gate 34, the transistor T1 and the depletion mode transistor T11.

The programming of the transistor T21 will now be described by way of example the programming of the transistors T22, T23, T24 and other transistors in the array being effected in the same manner as that to be described.

During the programming of any transistor the programming input terminal 20 will be held at a logically high level and therefore the input 19 to the NAND gate 18 and the input 35 to the AND gate 34 will also be logically high. The address fed to the address input 16 of the row decoder 13 will be such as to select the output 14a of that decoder which will go to a logically high level. The output of the NAND gate 18 will therefore go low and this will cause the field effect transistor T3 to be turned off. With no current flowing through the transistor T3 the potential at its drain electrode 26 will be the potential $V_{pp}$ applied to the terminal 28 since the depletion mode transistor T13 effectively behaves as a load resistor and with no current flowing through it there will be no potential drop between its drain electrode 27 and its source electrode 25. The row conductor 8 of the array 15 will therefore have the programming potential $V_{pp}$ applied to it and this potential will therefore be applied to the control gate electrode 6 of the transistor T21.

The address fed to the address input 32 of the column decoder 30 will also be such as to select the output 31a of the decoder and that output will be set logically high. The input 33 of the AND gate 34 will therefore be logically high as will the input 35 of that gate due to the logically high signal at the programming input 20.

If any selected transistor of the array is to be programmed with a logical 1 then when that transistor is selected by the row decoder 13 and the column decoder 30 the data input 37 will also be logically high.

Since this data input is connected to the input 36 of the AND gate 34 this gate will open and its output 38 will become logically high as will the control gate electrode 39 of the transistor T1 to which it is connected. This transistor T1 will therefore turn on and the programming potential $V_{pp}$ connected to the terminal 45 will be applied to the column conductor 10 and hence to the drain electrode 3 of the transistor T21.

-8-

The transistor T21 therefore has the requisite programming voltages applied to its control gate electrode 6 and to its drain electrode 3 and this transistor will therefore be programmed with a logical 1.

For any transistor which is to be programmed with a logical 0 the data input terminal 37 will be set to a logically low level when that transistor is selected. The programming of other transistors for example, via the outputs 14b and 31b of the row decoder 13 and the column decoder 30 respectively, are carried out in an identical manner.

It should be noted that when transistor T21 is being programmed, its control gate 6 and drain 3 are at the programming voltage $V_{pp}$. This means that column 10 and row 8 are at this high supply. Therefore the transistor T22 also located on row 8, as well as all devices that could have a gate connected to row 8, sustain programming voltage on their gate. As their drains are kept low, due to the fact that the column decoder 30 decodes only one column at a time, these devices will not program. This electric field generated by the gate high voltage only is called a gate stress. The electric field generated in a gate stress tends to deprogram an already programmed device.

Similarly, transistor T23 and all transistors connected to column 10 have a high drain voltage without gate programming voltage. No programming will occur, but a so called drain stress is present. The high electric field associated with a drain stress will also tend to deprogram a device.

As pointed out it is of prime importance that while programming a single memory element, elements adjacent to that element located on the same row or column of the array do not lose their stored charges. It is therefore essential that a memory array be tested following its manufacture.

The capacity of not losing charges under a drain or gate stress field can be associated to the good quality of the oxide surrounding the floating gate and ultimately to the good retentivity of a device under no stress condition.

Stress testing is therefore a good acceleration technique for checking the retentivity of a device. If stress testing is fast enough, it could replace the other standard acceleration method that consist of a bake of the device for 24 to 48 hours.

An embodiment of this invention describes a simple way of stressing all rows or all columns simultaneously. This makes stress testing economically interesting as the test time is greatly reduced.

In the test method and the array of the present invention rather than using a bake test, a stressing potential is applied to the rows and/or to the columns of the array and this potential when applied to the rows is applied to a plurality of the rows simultaneously so as to reduce testing time. When the potential is applied to the columns it is likewise applied simultaneously to a plurality of the columns. It is of course preferred that when the testing potential is applied to the rows it is applied simultaneously to all the rows and during testing by the application of the potential to the columns it is preferred to apply the potential simultaneously to all the columns.

The potential used as the testing potential is the programming potential $V_{pp}$. During its life the maximum stress which a device will have to stand is equal to the maximum programming time multiplied by the number of rows (or columns) minus one. In order to test the device it is essential that when applying the testing potential to the rows each row has the potential applied to it for this maximum time. Similarly in order to apply a testing potential to the columns of the array, each column must be stressed by the testing potential for this length of time.

In an array of 32 rows and columns, the row test time will therefore equal 32 x (32 - 1) x 50 milli. seconds = 49.6 seconds, 50 milli. seconds being the programming time of a single row. Similarly, each column must also have a testing potential applied for this period of time. If this testing potential was applied to each row sequentially and to each column sequentially the total testing time would be over 100 seconds.

As described with reference to Figure 3 a known memory array could be tested by the application of a testing potential to the rows and columns but it would only be possible to apply this potential sequentially to each row and then sequentially to each column.

However, in accordance with the present invention a testing potential is applied simultaneously to a plurality of rows and/or columns simultaneously. The way in which this is achieved in a practical embodiment will now be described with reference to Figures 4 and 5 of the drawings where like parts to those in Figure 3 bear like reference numerals.

Two additional inputs 46 and 47 are now provided and these inputs are used during the testing of the array. In order to apply a stress testing potential to the rows of the array a logical 1 signal is applied to the input terminal 46 and this signal causes the decoding action of the row decoder 13 and the column decoder 30 to be overriden so that all the rows of the array are selected and held at the programming potential simultaneously.

-10

When all the rows of the array are selected all the columns are held at 0. Likewise the application of a signal to the input 47 causes selection of all the columns of the array and the potential is applied to all these columns whilst all the rows of the array are held at 0. This action will now be described in more detail with respect to Figure 5.

The row outputs 14a and 14b are connected to one input of respective AND gates 48 and 49. A second input for each of the gates 48 and 49 is provided by the output of an AND gate 50 which has one input connected to the programming input 20 and a second input connected to the input terminal 47 via an inverting gate 51.

The AND gate 48 has an output connected to one input of a NOR gate 52 whilst the AND gate 49 similarly has its output connect to one input of a NOR gate 53. A second input for each of the NOR gates 52 and 53 is connect to the terminal 46. The NOR gate 52 has its output connected to the control gate of transistor T3 whilst the NOR gate 53 has its output connected to the control gate of the transistor T4.

The outputs 31 of the column decoder are each connected to one input of a respective AND gate 54 and 55 each of which has further inputs connected to the data input terminal 37 and to output 56 of an AND gate 57. The programming input terminal 20 is now connected to one input of the AND gate 57 a second input of which is connected to the terminal 46 via an inverter 58.

In operation it will be firstly assumed that a stressing potential in the form of the programming voltage $V_{pp}$ is to be applied simultaneously to each of the rows of the array 15. In this case a logical 1 is applied to the programming input terminal 20 and to the terminal 46. The terminal 46 is connected to one input of each of the NOR gates 52 and 53 and therefore each of the inputs to these gates will be at a logically high level. Each of the gates 52 and 53 will therefore have its output held at a logically low level and therefore the transistors T3 and T4 to which the outputs of these gates are respectively connected will be turned off. Consequently, each of the rows 8, 9 etc of the array 15 will receive a programming potential $V_{pp}$ since as seen previously this potential is applied to a row, for example to row 8 when the transistor T3 or its equivalent for other rows is turned off.

When the terminal 46 is logically high during the application of a stressing potential to the rows of the array the input of the AND gate 57 to which this terminal is connected will be held low due to the presence of the inverter 58.

-11-

The output terminal 56 of the AND gate 57 will therefore be low. One input to each of the AND gates 54 and 55 will therefore be low and also the gates 54 and 55 will have an output which is held logically low.

The outputs of the gates 54 and 55 are connected to one input of the OR gates 59 and 60 respectively, a second input of each of which is connected to the terminal 47. The OR gate 59 has an output terminal 61 connected to the control gate of the transistor T1 whilst the or gate 60 has an output 62 connected to the control gate of the transistor T2.

When the input terminal 46 is logically high the terminal 47 will always be logically low and consequently both inputs to the gates 59 and 60 will be low and therefore the outputs 61 and 62 respectively of these gates will also be low. The transistors T1 and T2 will therefore be turned off and consequently all the columns of the array will be held low. A stressing potential $V_{pp}$ is applied to each row, each column is held at 0 and the address decoding function of the row and column decoders 13 and 30 respectively is overriden.

In order to apply a stressing potential to the columns of the array, the input terminal 47 is held logically high while the terminal 46 is held low. In this case the input of the OR gates 59 and 60 connected to the terminal 47 will be high and since these gates are OR gates the outputs 61 and 62 will be logically high. The transistors T1 and T2 will be turned on and therefore each of the columns 10 and 11 will have the programming voltage $V_{pp}$ applied thereto.

The terminal 46 will be held logically low and therefore one input to each of the NOR gates 52 and 53 will be low. The input terminals 20 and 47 will be held logically high and therefore due to the presence of the inverter 51 connected between one input of the AND gate 50 and the terminal 47 this input to that gate will be held low and therefore the output of the gate will be low.

The output of the gate 50 is connected to one input of each of the AND gates 48 and 49 and therefore the outputs of each of these gates will be low. Consequently, both inputs to the NOR gates 52 and 53 will be low irrespective of the condition of the output 14 of the row decoder 13 and therefore the outputs of each of the gates 52 and 53 will be high. The transistors T3 and T4 will therefore be turned on and each of the row conductors 8, 9 etc will be held low.

The normal programming functions of the array are maintained when the programming input terminal 20 is held logically high and the input terminals 46 and 47 are held low. Under these circumstances OR gate 59 or 60 will only have a logically high output, (the condition required for programming a column) when its associated AND gate 54 and 55 respectively, has all three inputs held logically high. One input of each of the AND gates 54 and 55 is connected to the output terminal 56 of the AND gate 57 whose inputs will both be high when the programming input terminal is held logically high and the terminal 46 is held low. Assuming the data input terminal 37 is high then the only AND gate which can have a logically high output is that connected to an output 31 of the column decoder which is selected by the address fed to the address input 32.

In similar manner the only NOR gate, 52 and 53 to provide a logically low output to turn off a respective transistor T3 and T4 to programme a row will be that gate which receives a logical one at one of its inputs. Each of the gates 52 and 53 have one input connected to the terminal 46 which will be low during programming whilst the other terminal is connected to the output of a respective AND gate 48, 49. The only gate 48, 49 to be able to provide a logically high output will be that connected to a row output 14 of the row decoder 13 as selected by an address fed to the address input 16 of the decoder.

As illustrated therefore the embodiment of the invention shown in Figure 5 allows rapid stress testing of the transistors of the array by the application of testing potentials simultaneously to all its rows and and all its columns whilst allowing the normal programming action of a known memory array to be maintained. The invention allows a rapid stress test to replace a more lengthy bake or conventional stress bake.

The invention has been described by way of example and modifications may be made without departing from the scope of the invention. For example, although in the embodiment described all columns or all rows have test potentials applied to them simultaneously this is not absolutely essential and if desired any desired plurality of rows or columns could be selected for testing at any one time although this would not produce the same savings in testing time as would be achieved in the preferred embodiments described herein.

Another example of modification is to merge gates 48/52 and 49/53 in the decoder 13. (Similarly gates 54/59 and 55/60 for the decoder 30). This is not shown here as it's implementation depends on the chosen decoder structure.

The invention is particularly suitable for fabricating as an integrated circuit.

-13-

CLAIMS

1.     A method of testing an array of rows and columns of floating gate avalanche injection MOS memory elements, each element including a transistor having a source electrode, a drain electrode, a control gate electrode and a floating gate, the transistors in a row having their gate electrodes electrically connected together and the transistors in a column having their drain electrodes electrically connected together, the method including the steps of applying a stressing potential simultaneously to a plurality of rows or to a plurality of columns of the array.

2.     A method as claimed in claim 1 wherein the stressing potential is applied simultaneously to all the rows of the array.

3.     A method as claimed in claim 1 wherein the stressing potential is applied simultaneously to all the columns of the array.

4.     An array of rows and columns of floating gate avalanche injection MOS memory elements each element comprising a transistor having a source electrode, a drain electrode, a control gate electrode and a floating gate, the array including means for applying a stressing potential for test purposes simultaneously to a plurality of rows or to a plurality of columns of the array.

5.     An array as claimed in claim 4, wherein the means for applying a stressing potential includes means for applying a stressing potential simultaneously to all the rows of the array.

6.     An array as claimed in claim 4, wherein the means for applying a stressing potential includes means for applying a stressing potential simultaneously to all the columns of the array.

7.     An array as claimed in claim 4 or 5 or 6, wherein the array includes decoding means for enabling a programming potential to be applied to a selected row or column of the array the means for applying a stressing potential including means for overriding the action of the decoding means.

-14-

8.    An array as claimed in claim 7, wherein the means for overriding the action of the decoding means is operative to apply the programming potential and the stressing potential simultaneously to a plurality of rows or columns of the array.

9.    An array as claimed in claim 8, wherein the means for overriding the action of the decoding means comprises gating means for enabling application of the programming potential as the stressing potential.

10.    An array as claimed in claim 9, wherein the gating means is responsive to a stress test electing signal.

CONTROL GATE

POLY 6

INTERPOLY OXIDE →

7

⊖⊖⊖⊖⊖⊖ FLOATING GATE (POLY)

4  5

SOURCE N+    1    N+ DRAIN

2    SUBSTRATE P—    3

— PRIOR ART —

# FIG. 1

$V_{PP}$    GND

3   10   3   11

$T_{21}$    $T_{22}$

$V_{PP}$ ──────────── ROW 1

8   6   5   2   6   5   2

12   12

— PRIOR ART —

3   3

$T_{23}$    $T_{24}$

GND ──────────── ROW 2

9   6   5   2   6   5   2

12   12

# FIG. 2

32   30

ADDRESS LINES    COLUMN DECODER    DS

47

16   14   31   GS

31   46

13   ROW DECODER    EPROM ARRAY    15

47   46   14

DS   GS

# FIG. 4

FIG. 3

2/3

0101107

- PRIOR ART -

COLUMN DECODER (SELECTS 1 COLUMN OUT OF $n$ )

ROW DECODER (SELECTS 1 ROW OUT OF $m$)

MEMORY CORE ($n$ BY $m$)

# FIG. 5

COLUMN DECODER (SELECTS 1 COLUMN OUT OF $n$) 30

ADDRESS $\emptyset-i$ 32

GS 46 58

PG17 20

DS 47

51 50

37 31A 31B COL$n$ COL$n+1$

DATA

57 56

54 55

59 60

61 45 $V_{PP}$ 44 62 $V_{PP}$

$T_{11}$ $T_{12}$

39 $T_1$ $T_2$

ADDRESS $j-K$ 16 13

ROW $m$ 24 28 27 $V_{PP}$ $T_{13}$ 25

3 6 $T_{21}$ 2

ROW DECODER (SELECTS 1 ROW OUT OF $m$) 14A

26 8 $T_3$ 22 48 52 21 23

$T_{22}$

14B ROW $m+1$ $V_{PP}$ $T_{14}$

10 11 $T_{23}$ $T_{24}$

49 53 $T_4$ 9 15

MEMORY CORE ($n$ BY $m$)